# EUROPÄISCHE PATENTSCHRIFT

(11) **EP 2 132 791 B1**
(45) Veröffentlichungstag und Bekanntmachung des Hinweises auf die Patenterteilung: **20.07.2016**
(21) Anmeldenummer: 08708081.8
(22) Anmeldetag: 22.01.2008
(51) Int. Cl.: H01L 33/22, H01L 33/00, H01L 33/20

(54) **DÜNNFILM-LEUCHTDIODEN-CHIP UND VERFAHREN ZUR HERSTELLUNG EINES DÜNNFILM-LEUCHTDIODEN-CHIPS**
THIN-FILM LIGHT EMITTING DIODE CHIP AND METHOD FOR PRODUCING A THIN-FILM LIGHT EMITTING DIODE CHIP
PUCE À DIODES LUMINESCENTES À COUCHE MINCE ET PROCÉDÉ DE FABRICATION D'UNE PUCE À DIODES LUMINESCENTES À COUCHE MINCE

(30) Priorität: 29.01.2007 DE 102007004304
(43) Veröffentlichungstag der Anmeldung: 16.12.2009
(73) Patentinhaber: OSRAM Opto Semiconductors GmbH, 93055 Regensburg (DE)
(72) Erfinder: HERRMANN, Siegfried, 94362 Neukirchen (DE)
(74) Vertreter: Epping - Hermann - Fischer
(86) Internationale Anmeldenummer: PCT/EP2008/050716
(87) Internationale Veröffentlichungsnummer: WO 2008/092774

(56) Entgegenhaltungen:
- EP-A- 0 404 565
- WO-A-2005/099310
- WO-A1-2006/132013
- DE-A1-102005 013 894
- GB-A- 2 311 413
- JP-A- 2006 147 787
- US-A1- 2005 110 033
- US-A1- 2005 199 891
- US-A1- 2006 163 595
- SCHNITZER I ET AL: "30% EXTERNAL QUANTUM EFFICIENCY FROM SURFACE TEXTURED, THIN-FILM LIGHT-EMITTING DIODES" APPLIED PHYSICS LETTERS, AIP, AMERICAN INSTITUTE OF PHYSICS, MELVILLE, NY, US, Bd. 63, Nr. 16, 18. Oktober 1993 (1993-10-18), Seiten 2174-2176, XP000404433 ISSN: 0003-6951 in der Anmeldung erwähnt

## Beschreibung

Die Erfindung betrifft einen Dünnfilm-Leuchtdioden-Chip sowie ein Verfahren zu seiner Herstellung.

In der Offenlegungsschrift DE 100 40 448 A1 ist ein Halbleiterchip und ein Verfahren zur Herstellung von Halbleiterchips in Dünnschichttechnik beschrieben. Auf einem Substrat wird ein Schichtenverbund aus einer aktiven Schichtenfolge und einer Grundschicht angeordnet. Ferner werden dem Schichtenverbund eine Verstärkungsschicht und eine Hilfsträgerschicht hinzugefügt, die auf galvanischem Weg auf die Grundschicht aufgebracht werden, bevor das Substrat abgelöst wird. Auf der Seite des abgelösten Substrats wird zur Handhabung der aus dem Schichtenverbund gebildeten Halbleiterchips eine Folie auflaminiert.

Aus der Gebrauchsmusterschrift DE 202 200 258 U1 ist ein Halbleiterchip bekannt, der eine auf einem Substrat aufgewachsene Halbleiterschicht umfasst, die von einem Substrat durch Bestrahlen mit einem gepulsten Laserstrahl getrennt und mit ihrer von dem Substrat abgelösten Seite auf einen Träger aufgebondet ist.

Die Druckschriften US 2005/0110033 A1 und EP 0 404 565 A1 beschreiben Leuchtdiodenchips, bei denen das Substrat abgelöst ist und die Strahlung durch eine Hauptabstrahlfläche, die strukturiert oder aufgeraut ist, ausgekoppelt wird.

Die Druckschriften WO 2005/099310 A1, US 2005/0199891 A1, JP 2006-147787 A, GB 2311413 A, DE 102005013894 A1 und US 2006/0163595 A1 beschreiben jeweils Leuchtdiodenchips, die an zumindest einer Seite ein Substrat oder Trägersubstrat aufweisen.

Die Druckschrift WO 2006/132013 A1 beschreibt einen LED-Chip mit Wachstumssubstrat, bei dem zwei gegenüberliegende Hauptabstrahlflächen strukturiert sind. Eine Aufgabe der vorliegenden Erfindung ist es, einen Dünnfilm-Leuchtdioden-Chip mit verbesserter Abstrahlung anzugeben. Außerdem soll ein Verfahren angegeben werden, durch welches in einfacher Weise ein Dünnfilm-Leuchtdioden-Chip hergestellt werden kann, der eine gute Lichtabstrahlung aufweist.

Diese Aufgabe wird durch einen Dünnfilm-Leuchtdioden-Chip gemäß Anspruch 1 mit einem Schichtenstapel gelöst, der eine erste und eine gegenüber liegende zweite Hauptabstrahlfläche aufweist, so dass der Dünnfilm-Leuchtdioden-Chip zumindest zwei entgegengesetzte Hauptabstrahlrichtungen aufweist, wobei sowohl auf der ersten als auch auf der zweiten Hauptabstrahlfläche Maßnahmen vorgesehen sind zur Verbesserung der Auskopplung des in der Schichtenfolge erzeugten Lichts. Auf keiner Seite des Dünnfilm-Leuchtdiodenchips ist ein Substrat vorhanden, und die Abstrahlung in beide Hauptabstrahlrichtungen ist symmetrisch.

Bezüglich eines Verfahrens wird die Aufgabe durch ein Verfahren gemäß Anspruch 10 zur Herstellung eines Dünnfilm-Leuchtdioden-Chips gelöst, das die Schritte aufweist: Ausbilden einer zur Emission von Licht geeigneten Schichtenfolge, insbesondere aus einem Halbleitermaterial, auf einem Aufwachssubstrat, Ausbilden einer ersten elektrisch leitfähigen Kontaktmaterialschicht auf einer ersten Seite der aktiven Schichtenfolge, Strukturieren der ersten Kontaktmaterialschicht zur Ausbildung einer Kontaktfläche, Verbinden der strukturierten ersten Kontaktmaterialschicht mit einem Träger, Entfernen des Aufwachssubstrats, Ausbilden einer zweiten elektrisch leitfähigen Kontaktmaterialschicht auf einer zweiten, der ersten Seite der aktiven Schichtenfolge gegenüberliegenden Seite der aktiven Schichtenfolge, Strukturieren der zweiten Kontaktmaterialschicht zur Ausbildung einer Kontaktfläche und Trennen der strukturierten ersten Kontaktmaterialschicht von dem Träger. Bei dem Dünnfilm-Leuchtdioden-Chip handelt es sich also um ein Halbleiterbauelement, welches in zwei Hauptabstrahlrichtungen Licht aussendet. Dabei ist die Abstrahlung in beide Hauptabstrahlrichtungen symmetrisch. Eine wesentliche Voraussetzung dafür ist, dass auf keiner Seite des Dünnfilm-Leuchtdioden-Chips eine Substratschicht vorhanden ist, die Licht absorbieren könnte. Zumindest ist durch die symmetrische Ausgestaltung des Dünnfilm-Leuchtdioden-Chips sichergestellt, dass die Abstrahleigenschaften in beide Hauptabstrahlrichtungen gleich sind. Dadurch, dass auf den Hauptabstrahlflächen Maßnahmen vorgesehen sind zur Verbesserung der Auskopplung des in der Schichtenfolge erzeugten Lichts, wird die Effizienz des Dünnfilm-Leuchtdioden-Chips gesteigert. An den Grenzflächen des Schichtenstapels erfolgt ein Sprung der Brechungsindizes von dem Material des Schichtenstapels einerseits zu dem umgebenden Materials andererseits. Dadurch kommt es zu einer Brechung des Lichts beim Übergang vom Schichtenstapel in die Umgebung. Je nach Winkel, in dem ein Lichtstrahl beziehungsweise ein Photon auf die Grenzfläche auftrifft, kann es zur Totalreflektion kommen. Aufgrund der parallelen Oberflächen des Schichtenstapels trifft der reflektierte Lichtstrahl im gleichen Winkel auf der gegenüber liegenden Grenzfläche auf, so dass auch dort Totalreflektion auftritt. Die Folge ist, dass sich der Lichtstrahl in dem Schichtenstapel tot läuft und somit nichts zur Lichtabstrahlung beitragen kann. Dadurch, dass auf beiden Seiten Maßnahmen vorgesehen sind zur Verbesserung der Auskopplung des in der Schichtenfolge erzeugten Lichts, wird der Winkel verändert, in dem ein Lichtstrahl auf die Oberfläche auftrifft.

Unter Maßnahmen zur Verbesserung der Auskopplung sind vor allem Oberflächenstrukturierungen zu verstehen. Insbesondere kann eine Lichtauskopplung etwa durch eine Mikroprismenstrukturierung oder eine Rauhigkeitserhöhung der Hauptabstrahlflächen ermöglicht werden. Werden, wie in einer vorteilhaften Ausgestaltung der Erfindung, Aufrauungen der Oberfläche vorgesehen, ist dadurch eine unregelmäßige Oberfläche gebildet, die die Auskopplung von Licht verbessert. Werden, wie in einer anderen vorteilhaften Ausgestaltung der Erfindung, Auskoppelprismen vorgesehen, so entsteht in dem Bereich der Auskoppelprismen ebenfalls ein anderer Auftreffwinkel eines Lichtstrahls auf eine Grenzfläche als in zu den Auskoppelprismen benachbarten Bereichen der Hauptabstrahlflächen. Folglich ergeben sich in verschiedenen Bereichen der Hauptabstrahlflächen unterschiedliche Lagen der Grenzflächen, was die Auskopplung von Licht verbessert.

Eine weitere Maßnahme ist der Einsatz eines photonischen Kristalls z.B. als Schicht auf den Hauptabstrahlflächen des Schichtenstapels. Dadurch kann bewirkt werden, dass ein Teil der Strahlung, der unter einem Winkel gleich oder größer als dem Grenzwinkel ϑ auf den photonischen Kristall auftrifft, derart umgelenkt wird, dass er unter einem Winkel kleiner als dem Grenzwinkel ϑ auf eine Strahlungsauskoppelfläche auftrifft und somit auskoppeln kann.

Der photonische Kristall kann neben der optischen Funktion eine elektrische Funktion übernehmen und derart beschaffen sein, dass er zur Stromaufweitung dient, dass heißt der über Kontaktflächen zugeführte Strom wird in dem photonischen Kristall auf eine im Vergleich zu den Kontaktflächen größere Fläche des Schichtenstapels verteilt.

Bevorzugt sind sowohl der Einsatz photonischer Kristalle als auch Maßnahmen zur Verbesserung der Auskopplung, beispielsweise durch Oberflächenstrukturierungen, vorgesehen.

Eine Besonderheit der erfindungsgemäßen Dünnfilm-Leuchtdioden-Chips ist darin zu sehen, dass die Maßnahmen zur Verbesserung der Auskopplung des in der Schichtenfolge erzeugten Lichts auf beiden Oberflächen der Schichtenfolge vorgesehen sind. Denn konventionelle Techniken zur Erzeugung von Dünnfilm-Leuchtdioden-Chips erlauben es nicht, gleichartig ausgebildete Oberflächen auf zwei Seiten eines Schichtenstapels auszubilden.

Das erfindungsgemäße Verfahren ermöglicht es, einen symmetrischen Dünnfilm-Leuchtdioden-Chip herzustellen, durch das auf beiden Seiten einer Schichtenfolge Kontaktflächen durch strukturierte Kontaktmaterialschichten gebildet werden können sowie die Maßnahmen zur Verbesserung der Auskopplung des Lichts realisiert werden können. Während zunächst ein Aufwachssubstrat für die notwendige Stabilität der Schichtenfolge sorgt und so die Kontaktmaterialschichten beziehungsweise später die Kontaktflächen und die Maßnahmen zur Verbesserung der Auskopplung von Licht auf der einen Seite realisiert werden können, wird nachfolgend eine temporäre Trägerschicht auf die bereits strukturierte Seite aufgebracht, so dass auf der anderen Seite das Aufwachssubstrat entfernt und die zweite Seite bearbeitet werden kann zur Ausbildung von Kontaktflächen beziehungsweise zur Umsetzung der Maßnahmen zur Verbesserung der Auskopplung von Licht auf der zweiten Seite der Schichtenfolge.

Eine weitere Maßnahme zur Verbesserung der Effizienz des erfindungsgemäßen Dünnfilm-Leuchtdioden-Chips besteht darin, die Kontaktflächen so auszubilden, dass sie auf der zur Schichtenfolge hin gewandten Seite verspiegelt sind. Dadurch wird Licht nicht in den Kontaktflächen absorbiert, sondern reflektiert und auf der gegenüber liegenden Seite abgestrahlt. Da es sich um ein Bauelement handelt, welches in zwei Hauptabstrahlrichtungen Licht aussendet, geht das reflektierte Licht nicht verloren, sondern wird in die entgegen gesetzte Hauptabstrahlrichtung emittiert.

Zur Verbesserung der Stromaufweitung kann auf einer der beiden Oberflächen der Schichtenfolge oder auf beiden Oberflächen der Schichtenfolge eine Indium-Zinnoxyd (ITO) Schicht aufgebracht sein. Bevorzugt ist auf der Oberfläche der p-dotierten Schichtenfolge eine ITO-Schicht aufgebracht, wodurch sich die laterale Querleitfähigkeit auf der p-dotierten Seite des Dünnfilm-Leuchtdioden-Chips mit Vorteil verbessert.

Vorzugsweise ist auf der ITO-Schicht, die bevorzugt auf der Oberfläche der p-dotierten Schichtenfolge angeordnet ist, die Kontaktfläche aufgebracht. Dabei kann die ITO-Schicht ganzflächig auf der Oberfläche der p-dotierten Schichtenfolge aufgebracht sein.

Weitere vorteilhafte Ausgestaltungen des erfindungsgemäßen Chips beziehungsweise des erfindungsgemäßen Verfahrens sind in den Unteransprüchen angegeben.

Die Erfindung wird nachfolgend anhand von Ausführungsbeispielen näher erläutert. Es zeigt:
- Figur 1: einen Querschnitt durch einen erfindungsgemäßen Dünnfilm-Leuchtdioden-Chip,
- Figur 2: eine Draufsicht auf eine der Hauptabstrahlflächen des Dünnfilm-Leuchtdioden-Chips von Figur 1,
- Figur 3: eine dreidimensionale Ansicht eines Dünnfilm-Leuchtdioden-Chips mit anders gestalteten Kontaktflächen,
- Figur 4: eine Anordnung des Dünnfilm-Leuchtdioden-Chips nach Figur 1 oder Figur 3 und transparenten Trägerfolien und
- Figuren 5A bis 5H: einen Dünnfilm-Leuchtdioden-Chip nach Figur 1 oder Figur 3 in verschiedenen Phasen der Herstellung.

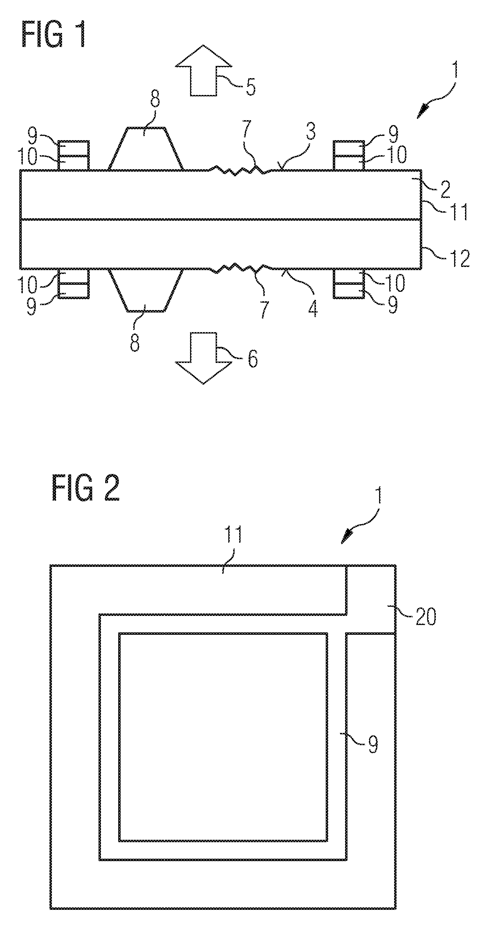

In der Figur 1 ist ein Dünnfilm-Leuchtdioden-Chip gezeigt, welcher auf zwei Hauptabstrahlflächen in zwei Hauptabstrahlrichtungen Licht emittiert.

Ein Dünnfilm-Leuchtdioden-Chip zeichnet sich insbesondere durch folgende charakteristische Merkmale aus:
- die Epitaxieschichtenfolge weist eine Dicke im Bereich von 20µm oder weniger, insbesondere im Bereich von 10 µm auf; und
- die Epitaxieschichtenfolge enthält mindestens eine Halbleiterschicht mit zumindest einer Fläche, die eine Durchmischungsstruktur aufweist, die im Idealfall zu einer annähernd ergodischen Verteilung des Lichtes in der epitaktischen Epitaxieschichtenfolge führt, d.h. sie weist ein möglichst ergodisch stochastisches Streuverhalten auf.

Ein Grundprinzip eines Dünnschicht-Leuchtdioden-Chips ist beispielsweise in I. Schnitzer et al., Appl. Phys. Lett. 63 (16), 18. Oktober 1993, 2174 - 2176 beschrieben, deren Offenbarungsgehalt insofern hiermit durch Rückbezug aufgenommen wird.

Ein Dünnfilm-Leuchtdioden-Chip ist in guter Näherung ein Lambert'scher Oberflächenstrahler und eignet sich von daher besonders gut für die Anwendung in einem Scheinwerfer.

Bei der Erfindung weist der Schichtenverbund eine aktive Schichtenfolge zur Erzeugung von elektromagnetischer Strahlung auf, die vorzugsweise epitaktisch auf einem Aufwachssubstrat aufgewachsen ist. Zur Erstellung einer Mehrzahl von Dünnfilm-Leuchtdioden-Chips wird ein großflächiger Schichtenverbund in einzelne Schichtenstapel zerteilt. Diese so genannte Vereinzelung kann beispielsweise durch Sägen geschehen. In der folgenden detaillierten Beschreibung von Ausführungsbeispielen der Erfindung wird der Aufbau eines einzelnen Dünnfilm-Leuchtdioden-Chips beschrieben beziehungsweise ein Verfahren zur Herstellung eines solchen Chips. Selbstverständlich erstreckt sich die Erfindung auch auf die gemeinsame Herstellung einer Vielzahl gleichartiger Dünnfilm-Leuchtdioden-Chips, die später vereinzelt werden.

Bei der beispielhaften Ausgestaltung nach Figur 1 ist eine p-dotierte Halbleiterschicht 11 und eine n-dotierte Halbleiterschicht 12 vorgesehen, die eine lichtemittierende Schichtenfolge bilden. Als Halbleitermaterial ist dabei vorzugsweise ein Nitrid-Verbindungshalbleiter vorgesehen, was bedeutet, dass der aktive Schichtenstapel oder zumindest eine Schicht davon ein Nitrid-III/V-Verbindungshalbleitermaterial, vorzugsweise AlₙGaₘIn₁₋ₙ₋ₘN, wobei 0 ≤ n ≤ 1, 0 ≤ m ≤ 1 und n+m ≤ 1 ist. Dabei muss dieses Material nicht zwingend eine mathematisch exakte Zusammensetzung nach obiger Formel aufweisen. Vielmehr kann es ein oder mehrere Dotierstoffe sowie zusätzliche Bestandteile aufweisen, die die charakteristischen physikalischen Eigenschaften des Halbleitermaterials im wesentlichen nicht ändern. Der Einfachheit halber beinhaltet obige Formel nur die wesentlichen Bestandteile des Kristallgitters (Al, Ga, En, N), auch wenn diese teilweise durch geringe Mengen weiterer Stoffe, beispielsweise P, ersetzt sein können. Ein Dünnfilm-Leuchtdioden-Chip, der einen Nitrid-Verbindungshalbleiter aufweist, emittiert hauptsächlich Strahlung mit einer Wellenlänge im kurzwelligen Bereich des sichtbaren optischen Spektrums.

Die weitere Ausbildung des Dünnfilm-Leuchtdioden-Chips ist auf der Oberseite und Unterseite gleichartig, so dass im folgenden nur auf die Oberseite 3 Bezug genommen wird. Die Oberseite 3 bildet eine der Hauptabstrahlflächen, wobei senkrecht zu dieser Fläche die erste Hauptabstrahlrichtung 5 liegt. Im Ausführungsbeispiel nach Figur 1 sind mehrere Maßnahmen entsprechend verschiedener Aspekte der Erfindung umgesetzt. Die einzelnen Maßnahmen können auch in abweichenden Ausführungen der Erfindung separat voneinander realisiert werden.

Eine erste Maßnahme ist die Aufrauung der Oberfläche 3, wobei durch die Aufrauungen 7 eine Verbesserung des Auskoppelverhaltens des in der Schichtenfolge 2 erzeugten Lichts erreicht wird. Das Licht findet im Bereich der Aufrauungen 7 sehr unterschiedliche Austrittswinkel vor, so dass die Wahrscheinlichkeit, nicht in einem zur Totalreflektion führenden Winkel auf die Grenzfläche aufzutreffen, erhöht ist. Diese Aufrauungen werden vorzugsweise durch Ätzen, also in einem nasschemischen Verfahren erzeugt. Kristalle besitzen üblicherweise auf der oberen und unteren Seite unterschiedliche Eigenschaften beim Ätzen, so dass es von Vorteil sein kann, die verschiedenen Seiten mit unterschiedlichen Methoden aufzurauen bzw. zu strukturieren.

Eine weitere Maßnahme ist das Vorsehen von Auskoppelprismen 8, die anstelle der Aufrauungen oder auch in Kombination mit diesen vorgesehen werden können. Durch die Auskoppelprismen wird ebenfalls der Winkel, in dem ein Lichtstrahl auf die Grenzfläche zur Umgebung auftrifft, gegenüber den angrenzenden Bereichen der Oberfläche 3 verändert. Somit besteht eine erhöhte Wahrscheinlichkeit, dass ein Lichtstrahl, der in diesen Bereich eindringt, bereits zuvor an einer anderen Stelle der Oberflächen 3 oder 4 reflektiert wurde.

Auskoppelprismen werden fotolithographisch strukturiert. Als Ätzmaske kann eine Schicht z.B. aus SiO₂ oder SiN Verwendung finden. Danach kann eine trockenchemische Ätzung erfolgen. Eine dritte Maßnahme ist eine Verspiegelung der Unterseiten von Kontaktflächen 9. Die Unterseiten sind dabei diejenigen Seiten der Kontaktflächen, welche zu der aktiven Schichtenfolge 2 weisen. Durch die Verspiegelungen 10 wird in der Schichtenfolge 2 erzeugtes Licht, welches normalerweise auf die Kontaktflächen 9 treffen würde und dort mit verhältnismäßig großer Wahrscheinlichkeit absorbiert wird, durch die Verspiegelung 10 zurück in die Schichtenfolge 2 reflektiert, wobei dieses Licht sodann auf die gegenüberliegende Grenzfläche auftrifft und dort die Schichtenfolge 2 verlassen kann. Mit Verspiegelungen vorgesehene Kontaktflächen 9 bewirken also eine Effizienzsteigerung, da weniger Licht absorbiert wird, sondern ein größerer Anteil des insgesamt erzeugten Lichts in eine der Hauptabstrahlrichtungen 5 oder 6 emittiert wird.

Als Abwandlungen der gezeigten und beschriebenen Ausgestaltung können die elektrischen Kontakte 9 auf den Auskoppelprismen 8 vorgesehen werden. Ebenso ist ein Versatz der oberen und unteren Kontakte 9 möglich, so dass eine unterschiedliche räumliche Lage entsteht. Dabei bleibt die Abstrahlcharakteristik im wesentlichen symmetrisch.

Zur Verbesserung der Stromaufweitung kann auf einer der beiden Oberflächen der Halbleiterschichten 11, 12 oder auf beiden Oberflächen der Halbleiterschichten 11, 12 eine Indium-Zinnoxyd (ITO) Schicht aufgebracht sein (nicht dargestellt). Bevorzugt ist auf der Oberfläche der p-dotierte Halbleiterschicht 11 eine ITO-Schicht aufgebracht, wodurch sich die laterale Querleitfähigkeit auf der p-dotierten Seite des Dünnfilm-Leuchtdioden-Chips mit Vorteil verbessert. In diesem Fall sind die Kontaktflächen 9, die vorzugsweise mit den Verspiegelungen 10 versehen sind, auf der ITO-Schicht angeordnet. Dabei kann die ITO-Schicht ganzflächig auf der Oberfläche der p-dotierten Halbleiterschicht 11 aufgebracht sein.

Der Schichtenstapel 2 mit den Schichten 11 und 12 weist typischerweise eine Höhe kleiner als 20 µm, bevorzugt kleiner als 10 µm auf. In einer besonders günstigen Ausgestaltung der Erfindung weist der Schichtenstapel eine Höhe von 7 µm auf. Ein Vorteil der geringen Höhe des Schichtenstapels ist, dass der Dünnfilm-Leuchtdioden-Chip dadurch flexibel ist und eine verringerte Gefahr besteht, dass er durch mechanische Beanspruchung zerstört wird. Dadurch können mit den erfindungsgemäßen Dünnfilm-Leuchtdioden-Chips flexible, leuchtende Folien hergestellt werden.

Der in Figur 1 gezeigte Chip kann mit einer Abdeckschicht versehen werden, um den Chip zu schützen beziehungsweise ihn in eine größere Einheit einzubetten. Die Abdeckschicht kann ein Konvertermaterial enthalten, welches durch Lumineszenz, das von dem Schichtenstapel erzeugte und emittierte Licht ganz oder teilweise in Licht einer anderen Wellenlänge, die typischerweise längerwellig ist, umwandelt. Leuchtstoffe werden dabei von dem in dem Schichtenstapel erzeugten Licht angeregt, so dass sie selber Strahlung emittieren. Das Konvertermaterial kann wie genannt in die Abdeckschicht integriert sein, es kann aber auch eine zusätzliche Konverterschicht ausgebildet werden.

In der Draufsicht nach Figur 2 ist zu erkennen, dass eine Kontaktfläche rahmenförmig auf der Oberseite 3 der aktiven Schichtenfolge 2 angeordnet ist. Der Vorteil der rahmenförmigen Ausgestaltung ist, dass wenig Fläche verbraucht wird, so dass die für die Lichtemission zur Verfügung stehende Fläche maximiert wird. Gleichzeitig ist aber eine gute Stromverteilung über die Oberfläche des Dünnfilm-Leuchtdioden-Chips gesichert. An einer Ecke des Chips ist eine Bondfläche 20 zu erkennen, die zur späteren Kontaktierung des Dünnfilm-Leuchtdioden-Chips 1 mit Leiterbahnen oder Bonddrähten dient. Die anhand von Figur 1 beschriebenen Maßnahmen zur Verbesserung der Auskopplung des in der Schichtenfolge erzeugten Lichts sind bei dem Chip nach Figur 2 ebenfalls vorgesehen, in der Figur aber nicht zu erkennen.

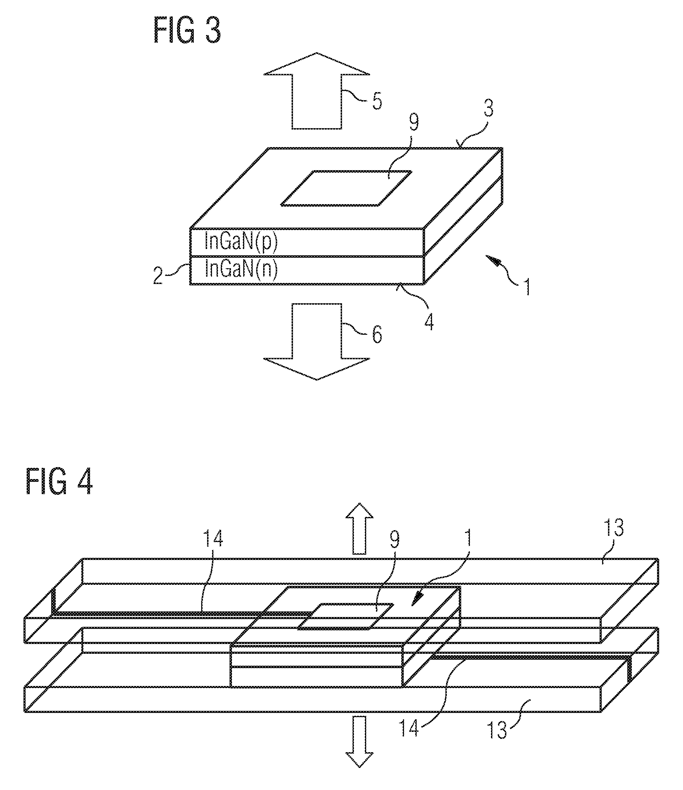

Die Figur 3 zeigt eine dreidimensionale Ansicht eines erfindungsgemäßen Dünnfilm-Leuchtdioden-Chips 1. Wie in der Figur 2 sind auch in dieser Figur die Maßnahmen zur Verbesserung der Auskopplung von Licht nicht zu erkennen. Im Unterschied zu der Ausführung nach Figuren 1 und 2 ist bei der Figur 3 im zentralen Bereich der Oberflächen der Hauptabstrahlflächen eine geschlossene Kontaktfläche 9 vorgesehen. Sie bedeckt eine Fläche von nur 10 bis 20 Prozent der Hauptabstrahlflächen, so dass eine ausreichend große Fläche zur Abstrahlung von Licht zur Verfügung steht.

In der Figur 4 ist zu erkennen, wie ein erfindungsgemäßer Dünnfilm-Leuchtdioden-Chip 1 mit Trägerfolien 13 verbunden werden kann, um so zu einer gebrauchsfertigen Anordnung zu gelangen. Die Trägerfolien 13, zwischen denen der Dünnfilm-Leuchtdioden-Chip 1 aufgenommen ist, sind aus einem transparenten Material, um die Abstrahlung in beide Hauptabstrahlrichtungen zu ermöglichen. Auf den den Dünnfilm-Leuchtdioden-Chip zugewandten Seiten der Trägerschichten 13 können Kontaktbahnen 14 vorgesehen sein, um eine elektrische Kontaktierung des Leuchtdioden-Chips zu ermöglichen. Vorzugsweise erfolgt die Kontaktierung über Indium-Zinnoxyd (ITO)-Kontakte, so dass kein Metall notwendig ist. Alternativ können die Kontaktbahnen 14 Gold oder Zinn aufweisen.

In Abwandlung der Anordnung von Figur 4 kann es von Vorteil sein, wenn die Kontaktflächen des Leuchtdioden-Chips 1 auf einer Seite des Leuchtdioden-Chips 1 liegen. Dann muss nur eine der Trägerfolien 13 mit Kontaktbahnen 14 versehen sein und ein Anschluss der Anordnung ist vereinfacht.

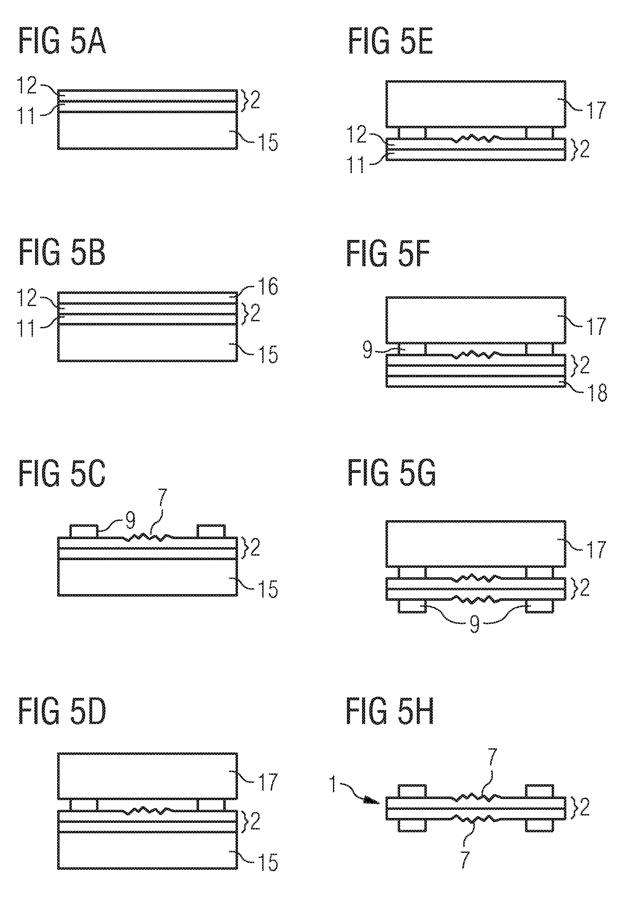

Anhand der Figuren 5A bis 5H wird nachfolgend erläutert, welche Schritte nach einem erfindungsgemäßen Verfahren durchgeführt werden, um einen Dünnfilm-Leuchtdioden-Chip herzustellen. In einem ersten Schritt wird auf einem Aufwachssubstrat 15 eine zur Lichtemission geeignete Schichtenfolge mit Schichten 11 und 12 ausgebildet. Dies kann beispielsweise durch epitaktisches Aufwachsen mehrerer unterschiedlicher Schichten, die vorzugsweise einen Nitrid-Verbindungshalbleiter enthalten, auf einem Saphir- oder SiC-Substrat erfolgen.

In der Figur 5B ist ein weiterer Herstellungsschritt dargestellt, bei dem auf die aktive Schichtenfolge mit den Schichten 11 und 12 eine Kontaktmaterialschicht 16 aufgebracht wird. Die Kontaktmaterialschicht 16 ist elektrisch leitfähig. Besonders vorteilhaft ist, wenn die Herstellung der Kontaktmaterialschicht 16 so erfolgt, dass sich auf der Unterseite eine Verspiegelung bildet, die in der aktiven Schichtenfolge erzeugtes Licht ohne Verluste beziehungsweise mit nur geringen Verlusten reflektiert. Die Verspiegelung wird beispielsweise durch eine Silberschicht oder eine silberhaltige Schicht realisiert.

Die Kontaktmaterialschicht 16 kann auf der Schichtenfolge mit den Schichten 11 und 12 ganzflächig aufgebracht sein. Alternativ kann die Kontaktmaterialschicht 16 partiell an den Stellen, z. B. durch eine Maske, aufgebracht sein, an denen später Kontaktflächen ausgebildet sein sollen.

Bei der Darstellung gemäß Figur 5B ist die Kontaktmaterialschicht 16 ganzflächig aufgebracht.

In dem Herstellungsschritt nach Figur 5C wird die Kontaktmaterialschicht 16 strukturiert, so dass Kontaktflächen 9 stehen bleiben und der Rest der Kontaktmaterialschicht 16 entfernt wird. Gleichzeitig oder in einem nachfolgenden Schritt kann die Oberfläche der Schichtenfolge mit den Schichten 11 und 12 aufgeraut werden, um die Auskopplung von in der aktiven Schichtenfolge erzeugtem Licht zu verbessern. In einer alternativen Ausgestaltung des Verfahrens wird das Aufrauen durchgeführt, bevor die Kontaktmaterialschicht aufgebracht wird. Nach der Strukturierung der Kontaktmaterialschicht ist dann die Aufrauung bereits vorhanden.

In einem weiteren Herstellungsschritt gemäß Figur 5D wird ein Träger 17 auf die Reste der Kontaktmaterialschicht 16 aufgebracht, die nach Figur 5D nur noch aus den Kontaktflächen 9 besteht. Nach dem Aufbringen des Trägers 17 ist die Stabilität der Schichtenfolge mit den Schichten 11 und 12 für die weitere Bearbeitung durch den Träger 17 sichergestellt, so dass das Aufwachssubstrat 15 entfernt werden kann. Der entsprechende Schritt ist in der Figur 5E dargestellt. Das Ablösen des Aufwachssubstrats 15 kann beispielsweise durch ein Laserablöseverfahren erfolgen, wie es beispielsweise aus der WO98/14986 bekannt ist. Im wesentlichen wird bei einem Laserablöseverfahren durch das Aufwachssubstrat 15 hindurch eine Grenzfläche zwischen dem Aufwachssubstrat 15 und der aktiven Schichtenfolge mit elektromagnetischer Strahlung, vorzugsweise Laserstrahlung, bestrahlt, so dass an der Grenzfläche durch Absorption der Strahlung eine Materialzersetzung stattfindet. Dadurch lassen sich das Aufwachssubstrat 15 und die aktive Schichtenfolge 2 im wesentlichen zerstörungsfrei voneinander trennen. Das Aufwachssubstrat 15 kann sogar wieder verwendet werden. Alternativ kann die Ablösung des Aufwachssubstrats durch Ätzen oder ein sonstiges geeignetes Abhebeverfahren erfolgen.

Um auch auf der anderen Seite eine zur Lichtabstrahlung und gleichzeitig Kontaktierung geeignete Flächenstruktur zu erhalten, wird in einem weiteren Herstellungsschritt gemäß Figur 5F eine zweite Kontaktmaterialschicht 18 auf die andere Seite der aktiven Schichtenfolge 2 aufgebracht. Wie auch bei der ersten Kontaktmaterialschicht 16 wird die zweite Kontaktmaterialschicht 18 nachfolgend strukturiert (Figur 5G), so dass Kontaktflächen 9 erhalten werden. Gleichzeitig oder nachfolgend kann eine Aufrauung der unteren Oberfläche erfolgen, um die Auskopplung zu verbessern. Während dieser Bearbeitungsschritte wird die Stabilität wie oben genannt durch den Träger 17 gewährleistet.

Im abschließenden Schritt gemäß Figur 5H wird der Träger 17 entfernt, so dass ein zur Weiterverarbeitung zur Verfügung stehender Dünnfilm-Leuchtdioden-Chip erhalten wird.

Statt der Aufrauung der Oberflächen können auch Auskoppelprismen oder andere Maßnahmen, die dazu geeignet sind, die Auskopplung von in der aktiven Schichtenfolge 2 erzeugtem Licht zu verbessern, eingesetzt werden.

Sowohl das Aufrauen als auch das Erzeugen von Auskoppelprismen kann durch Ätzen erfolgen, d. h. es werden Strukturen in die bestehende Oberfläche geätzt. In einer anderen, alternativ anzuwendenden Technik erfolgt die Bearbeitung der Oberfläche mit einem Ionenplasma auf trockenchemischem Weg.

Die Trägerfolie 13 kann ein Kunststoffmaterial enthalten. Für die Trägerfolie 13 bevorzugte Materialien sind beispielsweise Glas, ein Epoxidharz, PET, ein Polymer, insbesondere Polyimid, beispielsweise Kapton, oder eine Kombination dieser Materialien.

Darüber hinaus enthält die Trägerfolie bei einer bevorzugten Ausführungsform Kohlefasern. Diese können beispielsweise in einen Polymerfilm eingebettet sein und eine höhere thermische Leitfähigkeit aufweisen als der Polymerfilm, so dass sich daraus vorteilhafterweise insgesamt eine haftende und thermisch leitende Trägerschicht ergibt.

Außerdem kann die Trägerschicht ein Glasgewebe, insbesondere ein Silikat, aufweisen. Insbesondere sind auch ITO (Indium-Zinnoxyd)-beschichtete Glasfolien geeignet.

Für die Kontaktbahnen ist es von Vorteil, wenn leitfähige und gleichzeitig transparente Materialien verwendet werden, was bei so genannten "transparent conductive oxide" (TCO) der Fall ist. Ein geeignetes Material ist Indium-Zinnoxyd (ITO).

Als untere Grenze für die Dicke der strahlungsemittierenden Schichtenfolge 2 sind nach der Erfindung 6 µm vorgesehen. Die Obergrenze liegt bei ca. 20 µm.

Eine weitere Maßnahme zur Bildung von Auskoppelstrukturen ist das Vorsehen von photonischen Kristallen, z.B. als zusätzliche Schicht auf den Hauptabstrahlflächen 3 und 4 des Schichtenstapels 2. Vorzugsweise umfasst der photonische Kristall eine Mehrzahl von ersten Bereichen mit einem ersten Brechungsindex und eine Mehrzahl von zweiten Bereichen mit einem zweiten Brechungsindex. Besonders bevorzugt sind die Bereiche regelmäßig angeordnet. Die regelmäßige Anordnung kann einem eindimensionalen, zweidimensionalen oder dreidimensionalen Gitter entsprechen. Insbesondere kann der photonische Kristall im Rahmen der Erfindung die Struktur eines zweidimensionalen Gitters aufweisen. Dabei entspricht der Abstand zwischen zwei benachbarten ersten Bereichen beziehungsweise zwei benachbarten zweiten Bereichen der Gitterkonstante. Der photonische Kristall erzielt seine Wirkung am besten, wenn die Gitterkonstante an eine Wellenlänge der von dem Halbleiterkörper erzeugten Strahlung angepasst ist. Vorzugsweise entspricht der Abstand zwischen zwei benachbarten ersten Bereichen beziehungsweise zwei benachbarten zweiten Bereichen ungefähr der Wellenlänge der von dem Schichtenstapel erzeugten Strahlung. Besonders bevorzugt liegt der Abstand zwischen 10⁻⁹ m und 10⁻⁶ m.

Neben der beschriebenen Bauform, bei der der Dünnfilm-Leuchtdioden-Chip zwischen transparenten Folien aufgenommen wird, kann auch eine Vergussbauform realisiert werden, wobei das beidseitig verwendete Vergussmaterial transparent ist. Ein besonderes Augenmerk muss auf die Wärmedissepation gerichtet werden. Um eine ausreichende Wärmeableitung sicher zu stellen, kann als Trägerfolie 13 ein silbergefüllter Epoxydklebstofffilm verwendet werden, der 80 Prozent Silber und 20 Prozent nicht flüchtiges Epoxydharz enthält. Der silbergefüllte Epoxydklebstoff wird auf den Dünnfilm-Leuchtdioden-Chip 1 aufgebracht und anschließend auf 80° C bis 90° C erhitzt. Dabei wird der Klebstofffilm leicht aufgeschmolzen, wodurch er eine gute Primärhaftung erhält. Nachfolgend wird der Film bei Temperaturen von ungefähr 150° C ausgehärtet. Die so entstandene Trägerschicht 2 ist elektrisch leitfähig und weist eine Gasübergangstemperatur von 150 bis 155° C auf. Ferner ist die Trägerschicht 13 thermisch und chemisch beständig. Aufgrund der geringen Dicke ist trotzdem eine gewisse Elastizität gegeben. Für die Trägerschicht 13 kann aber insbesondere auch jedes andere Material, vorzugsweise Kunststoffmaterial, verwendet werden, das Eigenschaften aufweist, die den beispielhaft anhand des Epoxydklebstofffilms verdeutlichten Eigenschaften entsprechen.

Weiterhin kann eine allseitige Passivierung des Chips z. B. mit Siliziumdioxyd (SiO₂) vorgesehen werden.

Die Trägerfolie kann entweder insgesamt elektrisch leitend ausgestaltet werden oder es werden nur Leiterbahnen wie in Figur 4 dargestellt realisiert, während die restlichen Bereiche der Trägerfolien 13 nicht leitend sind.

Bei einer weiteren Ausgestaltung kann der Dünnfilm-Leuchtdioden-Chip in einer Beleuchtungseinrichtung oder in einem Sensor Anwendung finden.

Die verschiedenen Maßnahmen zur Verbesserung der Auskopplung von Licht sind nicht nur in Verbindung miteinander einsetzbar, sondern auch jeweils für sich genommen allein. Auch sind die Verspiegelungen der Kontaktflächen 9 nicht mit den Aufrauungen beziehungsweise Auskoppelprismen notwendigerweise in Kombination einzusetzen, sondern jede der Maßnahmen kann unabhängig voneinander verwendet werden.

## Patentansprüche

1. Dünnfilm-Leuchtdioden-Chip (1) mit einem Schichtenstapel (2), der eine erste und eine gegenüberliegende zweite Hauptabstrahlfläche (3, 4) aufweist, wobei beide Hauptabstrahlflächen (3, 4) Hauptflächen des Dünnfilm-Leuchtdioden-Chips (1) sind und parallel zu den Hauptflächen der Schichten verlaufen, so dass der Dünnfilm-Leuchtdioden-Chip (1) zwei entgegengesetzte Hauptabstrahlrichtungen (5, 6) senkrecht zu den Hauptabstrahlflächen (3, 4) aufweist,
wobei
- sowohl auf der ersten als auch auf der zweiten Hauptabstrahlfläche (3, 4) Maßnahmen vorgesehen sind zur Verbesserung der Auskopplung des in der Schichtenfolge (2) erzeugten Lichts,
- auf keiner Seite des Dünnfilm-Leuchtdiodenchips (1) ein Substrat vorhanden ist, und
- die Ausgestaltung des Dünnfilm-Leuchtdioden-Chips (1) symmetrisch ist, so dass die Abstrahleigenschaften in beide Hauptabstrahlrichtungen (5, 6) gleich sind.

2. Dünnfilm-Leuchtdioden-Chip nach Anspruch 1,
bei dem zur Verbesserung der Auskopplung des in der Schichtenfolge (2) erzeugten Lichts die Hauptabstrahlflächen (3, 4) der Schichtenfolge (2) zumindest partiell aufgeraut ist.

3. Dünnfilm-Leuchtdioden-Chip nach Anspruch 2,
bei dem die Strukturgröße der Aufrauungen (7) circa 350 nm beträgt.

4. Dünnfilm-Leuchtdioden-Chip nach Anspruch 1,
bei dem zur Verbesserung der Auskopplung des der Schichtenfolge (2) erzeugten Lichts auf den Hauptabstrahlflächen (3, 4) Auskoppelprismen ausgebildet sind.

5. Dünnfilm-Leuchtdioden-Chip nach Anspruch 1,
bei dem auf zumindest einer der Hauptabstrahlflächen (3, 4) Kontaktflächen (9) vorgesehen sind zum Anschluss des Dünnfilm-Leuchtdioden-Chips.

6. Dünnfilm-Leuchtdioden-Chip nach Anspruch 5,
bei dem auf der der Schichtenfolge (2) zugewandten Seite der Kontaktflächen (9) eine Verspiegelung (10) vorgesehen ist.

7. Dünnfilm-Leuchtdioden-Chip nach einem der Ansprüche 1 bis 6,
bei dem die Kontaktflächen (9) streifenförmig, insbesondere rahmenförmig ausgestaltet sind zur Stromverteilung auf verschiedene Bereiche der Schichtenfolge (2).

8. Dünnfilm-Leuchtdioden-Chip nach einem der Ansprüche 1 bis 7,
bei dem die Dicke der Schichtenfolge (2) zwischen 5 und 15 µm liegt.

9. Dünnfilm-Leuchtdioden-Chips nach einem der Ansprüche 1 bis 8,
bei dem die Schichtenfolge aneinander angrenzende Schichten (11, 12) aus einem n-dotierten InGaN und einem p-dotierten InGaN aufweist.

10. Verfahren zur Herstellung eines Dünnfilm-Leuchtdioden-Chips gemäß Anspruch 1, der zwei entgegengesetzte Hauptabstrahlrichtungen (5, 6) aufweist, mit den Schritten:
▪ Ausbilden einer zur Emission von Licht geeigneten Schichtenfolge (2) insbesondere aus einem Halbleitermaterial auf einem Aufwachssubstrat (15),
▪ Ausbilden einer ersten elektrisch leitfähigen Kontaktmaterialschicht (16) auf einer ersten Seite der aktiven Schichtenfolge,
▪ Strukturieren der ersten Kontaktmaterialschicht (16) zur Ausbildung einer Kontaktfläche (9),
▪ Verbinden der strukturierten ersten Kontaktmaterialschicht mit einem Träger (17),
▪ Entfernen des Aufwachssubstrats (15),
▪ Ausbilden einer zweiten elektrisch leitfähigen Kontaktmaterialschicht (18) auf einer zweiten, der ersten Seite der aktiven Schichtenfolge gegenüberliegenden Seite der aktiven Schichtenfolge,
▪ Strukturieren der zweiten Kontaktmaterialschicht (18) zur Ausbildung einer Kontaktfläche (9),
▪ Trennen der strukturierten ersten Kontaktmaterialschicht (16) von dem Träger (17).

11. Verfahren nach Anspruch 10 ,
wobei die von der ersten Kontaktmaterialschicht (16) befreiten Bereiche der aktiven Schichtenfolge (2) an ihre Oberflächen (3) und/oder die von der zweiten Kontaktmaterialschicht (18) befreiten Bereiche der aktiven Schichtenfolge (2) an ihrer Oberfläche (4) aufgeraut werden, insbesondere durch ein nasschemisches Verfahren.

12. Verfahren nach Anspruch 10 ,
wobei während oder nach der Strukturierung der ersten und/oder zweiten Kontaktmaterialschicht (16, 18) Auskoppelprismen auf der Oberfläche der aktiven Schichtenfolge gebildet werden.

13. Verfahren nach Anspruch 10 ,
wobei die Kontaktmaterialschichten (16, 18) derart aufgebracht werden, dass die der aktiven Schichtenfolge zugewandten Seiten verspiegelt sind.

## Claims

1. Thin-film light-emitting diode chip (1) comprising a layer sequence (2) having a first and an opposite second main emission surface (3, 4), wherein both main emission surfaces (3, 4) are main surfaces of the thin-film light-emitting diode chip (1) and run parallel to the main surfaces of the layers, such that the thin-film light-emitting diode chip (1) has two opposite main emission directions (5, 6) perpendicular to the main emission surfaces (3, 4), wherein
- both on the first and on the second main emission surface (3, 4) measures are provided for improving the coupling out of the light generated in the layer sequence (2),
- a substrate is present on no side of the thin-film light-emitting diode chip (1), and
- the configuration of the thin-film light-emitting diode chip (1) is symmetrical, such that the emission properties are identical in both main emission directions (5, 6).

2. Thin-film light-emitting diode chip according to claim 1,
wherein, for improving the coupling out of the light generated in the layer sequence (2), the main emission surfaces (3, 4) of the layer sequence (2) are at least partially roughened.

3. Thin-film light-emitting diode chip according to claim 2,
wherein the feature size of the roughenings (7) is approximately 350 nm.

4. Thin-film light-emitting diode chip according to claim 1,
wherein, for improving the coupling out of the light generated in the layer sequence (2), coupling-out prisms are formed on the main emission surfaces (3, 4).

5. Thin-film light-emitting diode chip according to claim 1,
wherein on at least one of the main emission surfaces (3, 4) contact pads (9) are provided for the connection of the thin-film light-emitting diode chip.

6. Thin-film light-emitting diode chip according to claim 5,
wherein a reflective coating (10) is provided on that side of the contact pads (9) which faces the layer sequence (2).

7. Thin-film light-emitting diode chip according to any of claims 1 to 6,
wherein the contact pads (9) are configured in a strip-shaped fashion, in particular in a frame-shaped fashion, for current distribution among different regions of the layer sequence (2).

8. Thin-film light-emitting diode chip according to any of claims 1 to 7,
wherein the thickness of the layer sequence (2) is between 5 and 15 µm.

9. Thin-film light-emitting diode chip according to any of claims 1 to 8,
wherein the layer sequence has mutually adjoining layers (11, 12) composed of an n-doped InGaN and a p-doped InGaN.

10. Method for producing a thin-film light-emitting diode chip according to claim 1, which has two opposite main emission directions (5, 6) comprising the following steps:
- forming a layer sequence (2) suitable for emitting light and made in particular from a semiconductor material on a growth substrate (15),
- forming a first electrically conductive contact material layer (16) on a first side of the active layer sequence,
- structuring the first contact material layer (16) to form a contact pad (9),
- connecting the structured first contact material layer to a carrier (17),
- removing the growth substrate (15),
- forming a second electrically conductive contact material layer (18) on a second side of the active layer sequence, said second side being situated opposite the first side of the active layer sequence,
- structuring the second contact material layer (18) to form a contact pad (9),
- separating the structured first contact material layer (16) from the carrier (17).

11. Method according to claim 10,
wherein the regions of the active layer sequence (2) which are freed of the first contact material layer (16) are roughened at their surfaces (3) and/or the regions of the active layer sequence (2) which are freed of the second contact material layer (18) are roughened at their surface (4), in particular by means of a wet-chemical method.

12. Method according to claim 10,
wherein coupling-out prisms are formed on the surface of the active layer sequence during or after the structuring of the first and/or second contact material layer (16, 18).

13. Method according to claim 10,
wherein the contact material layers (16, 18) are applied in such a way that the sides facing the active layer sequence are reflectively coated.

## Revendications

1. Puce à diodes électroluminescentes à couche mince (1) comprenant une suite de couches (2), qui présente une première surface de rayonnement principale et une deuxième surface de rayonnement principale opposée (3, 4), dans laquelle les deux surfaces de rayonnement principales (3, 4) sont des surfaces principales de la puce à diodes électroluminescentes à couche mince (1) et s'étendent parallèlement aux surfaces principales des couches, de manière à ce que la puce à diodes électroluminescentes à couche mince (1) présente deux directions de rayonnement principales opposées (5, 6) perpendiculairement aux surfaces de rayonnement principales (3, 4),
dans lequel
- des mesures sont prévues à la fois sur la première et sur la deuxième surface de rayonnement principale (3, 4) en vue d'une amélioration de l'extraction de la lumière générée dans la suite de couches (2),
- aucun substrat n'est présent sur une face de la puce à diodes électroluminescentes à couche mince (1), et
- la configuration de la puce à diodes électroluminescentes à couche mince (1) est symétrique de manière à ce que les propriétés de rayonnement soient identiques dans les deux directions de rayonnement principales (5, 6).

2. Puce à diodes électroluminescentes à couche mince selon la revendication 1,
dans laquelle les surfaces de rayonnement principales (3, 4) de la suite de couches (2) sont rendues au moins partiellement rugueuses pour améliorer l'extraction de la lumière générée dans la suite de couches (2).

3. Puce à diodes électroluminescentes à couche mince selon la revendication 2,
dans laquelle la taille des structures des rugosités (7) est d'environ 350 nm.

4. Puce à diodes électroluminescentes à couche mince selon la revendication 1,
dans laquelle des prismes d'extraction sont formés sur les surfaces de rayonnement principales (3, 4) pour améliorer l'extraction de la lumière générée par la suite de couches (2).

5. Puce à diodes électroluminescentes à couche mince selon la revendication 1,
dans laquelle des surfaces de contact (9) sont prévues sur au moins l'une des surfaces de rayonnement principales (3, 4) pour la connexion de la puce à diodes électroluminescentes à couche mince.

6. Puce à diodes électroluminescentes à couche mince selon la revendication 5,
dans laquelle une métallisation (10) est prévue sur le côté des surfaces de contact (9) qui est opposé à la suite de couches (2).

7. Puce à diodes électroluminescentes à couche mince selon l'une quelconque des revendications 1 à 6, dans laquelle les surfaces de contact (9) sont réalisées sous la forme de bandes, notamment sous la forme de cadres pour la répartition du courant sur les différentes zones de la suite de couches (2).

8. Puce à diodes électroluminescentes à couche mince selon l'une quelconque des revendications 1 à 7, dans laquelle l'épaisseur de la suite de couches (2) se situe entre 5 et 15 µm.

9. Puce à diodes électroluminescentes à couche mince selon l'une quelconque des revendications 1 à 8, dans laquelle la suite de couches comporte des couches adjacentes les unes aux autres (11, 12) constituées d'un InGaN dopé n et d'un InGaN dopé p.

10. Procédé de fabrication d'une puce à diodes électroluminescentes à couche mince selon la revendication 1, présentant deux directions de rayonnement principales opposées (5, 6), comportant les étapes consistant à :
- réaliser une suite de couches (2) appropriée pour l'émission de lumière, notamment constituée d'un matériau à semi-conducteur sur un substrat de croissance (15),
- réaliser une couche de matériau de contact (16) électriquement conductrice sur un premier côté de la suite de couches active,
- structurer la première couche de matériau de contact (16) pour former une surface de contact (9),
- lier la première couche de matériau de contact à un support (17),
- enlever le substrat de croissance (15),
- réaliser une deuxième couche de matériau de contact électriquement conductrice (18) sur un deuxième côté de la suite de couches active qui est opposé au premier côté de la suite de couches active,
- structurer la deuxième couche de matériau de contact (18) pour former une surface de contact (9),
- séparer la première couche de matériau structuré (16) du support (17).

11. Procédé selon la revendication 10,
dans lequel les zones de la suite de couches active (2) libérées de la première couche de matériau de contact (16) sont rendues rugueuses sur leurs surfaces (3) et/ou les zones de la suite de couches active (2) libérées de la deuxième couche de matériau de contact (18) sont rendues rugueuses sur leur surface (4), notamment par un procédé de gravure chimique par voie humide.

12. Procédé selon la revendication 10,
dans lequel, pendant ou après la structuration de la première et/ou de la deuxième couche de matériau de contact (16, 18), des prismes d'extraction sont formés sur la surface de la suite de couches active.

13. Procédé selon la revendication 10,
dans lequel les couches de matériau de contact (16, 18) sont déposées de manière à métalliser les côtés opposés de la suite de couches active.
